(19) Europäisches Patentamt
European Patent Office
Office européen des brevets

(11) **EP 2 924 751 B1**

(12) **FASCICULE DE BREVET EUROPEEN**

(45) Date de publication et mention
de la délivrance du brevet:
**25.01.2017 Bulletin 2017/04**

(51) Int Cl.:
**H01L 45/00** *(2006.01)* **G11C 13/00** *(2006.01)*

(21) Numéro de dépôt: **15160356.0**

(22) Date de dépôt: **23.03.2015**

(54) **DISPOSITIF DE MÉMOIRE VIVE RÉSISTIVE**

RESISTIVE ARBEITSSPEICHERVORRICHTUNG

RESISTIVE RANDOM ACCESS MEMORY DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.03.2014 FR 1452573**

(43) Date de publication de la demande:
**30.09.2015 Bulletin 2015/40**

(73) Titulaires:
• **COMMISSARIAT A L'ENERGIE ATOMIQUE ET AUX
ENERGIES ALTERNATIVES
75015 Paris (FR)**
• **Altis Semiconductor
75008 Paris (FR)**

(72) Inventeurs:
• **Molas, Gabriel
38000 GRENOBLE (FR)**
• **Blaise, Philippe
38000 GRENOBLE (FR)**

• **Dahmani, Faiz
94210 LA VARENNE SAINT-HILAIRE (FR)**
• **Gassilloud, Rémy
38380 SAINT-LAURENT-DU-PONT (FR)**
• **Vianello, Elisa
38000 GRENOBLE (FR)**

(74) Mandataire: **Cabinet Camus Lebkiri
25 rue de Maubeuge
75009 Paris (FR)**

(56) Documents cités:
EP-A2- 2 141 753          WO-A2-2010/118380
US-A1- 2010 078 758      US-A1- 2012 292 587
US-A1- 2013 082 228

• **YU-CHIH HUANG ET AL: "Superior resistive switching characteristics of Cu-TiO2 based RRAM cell", NANOELECTRONICS CONFERENCE (INEC), 2013 IEEE 5TH INTERNATIONAL, IEEE, 2 janvier 2013 (2013-01-02), pages 236-239, XP032334276, DOI: 10.1109/INEC.2013.6466009 ISBN: 978-1-4673-4840-9**

EP 2 924 751 B1

**Description**

**DOMAINE TECHNIQUE DE L'INVENTION**

La présente invention concerne le domaine des mémoires réinscriptibles non volatiles, et plus spécifiquement celui des mémoires vives résistives. Une mémoire vive résistive comprend des première et seconde électrodes séparées par une couche en matériau électriquement isolant, et passe d'un état isolant à un état conducteur par formation d'un filament conducteur entre les première et seconde électrodes.

**ARRIERE-PLAN TECHNOLOGIQUE DE L'INVENTION**

Les mémoires vives à résistance variable (appelées mémoires RRAM pour « Resistive Random Access Memories » en anglais) sont aujourd'hui le sujet d'une grande attention, en raison notamment de leur faible consommation électrique et leur vitesse de fonctionnement élevée.

Une cellule mémoire de type résistive présente au moins deux états : un état fortement résistif « HRS » (« High Resistance State »), appelé également état « OFF », et un état faiblement résistif « LRS » (« Low Resistance State ») ou état « ON ». Elle peut donc être utilisée pour stocker une information binaire.

On peut distinguer trois types de mémoires résistives : les mémoires à base de mécanisme thermochimique, les mémoires à base de changement de valence, et les mémoires à base de métallisation électrochimique.

Le domaine de la présente invention concerne plus particulièrement cette dernière catégorie basée sur des matériaux à conduction ionique (mémoires CBRAM ou « Conductive Bridging RAM »). Le fonctionnement réside dans la formation et la rupture réversibles d'un filament conducteur dans un électrolyte solide, par dissolution d'une électrode soluble. Ces mémoires sont prometteuses de par leur faibles tensions de programmation (de l'ordre du Volt), leur temps de programmation court (<1 $\mu$s), leur faible consommation et leur faible coût d'intégration. De plus, ces mémoires peuvent être intégrées dans les niveaux de métallisation de la logique d'un circuit (« above IC »), ce qui permet d'augmenter la densité d'intégration du circuit. Du point de vue de l'architecture, elles requièrent seulement un dispositif de sélection, un transistor ou une diode par exemple.

Le fonctionnement des mémoires CBRAM est basé sur la formation, au sein d'un électrolyte solide, d'un ou plusieurs filaments métalliques (appelés également « dendrites ») entre deux électrodes, lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament métallique, de manière à supprimer ou à réduire considérablement la conduction électrique due à la présence du filament.

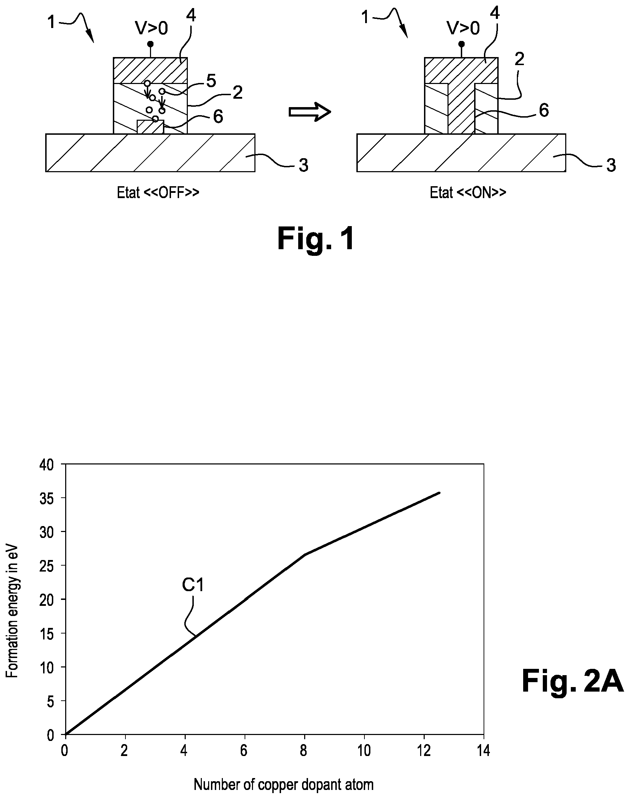

La figure 1 illustre schématiquement le passage d'un état « OFF » à un état « ON » pour un dispositif mémoire 1 de type CBRAM.

Ce dispositif 1 est formé par un empilement de type Métal/Conducteur ionique/Métal. Il comporte un électrolyte solide 2, par exemple à base de chalcogénure dopé (ex. GeS) ou d'oxyde (ex. $Al_2O_3$). L'électrolyte 2 est disposé entre une électrode inférieure 3, par exemple en Pt, formant une cathode inerte, et une électrode supérieure 4 comportant une portion de métal ionisable, par exemple du cuivre, et formant une anode. Une portion de métal ionisable est une portion de métal pouvant former des ions métalliques (ici des ions $Cu^{2+}$), lorsqu'elle est soumise à un potentiel électrique approprié. Le dispositif 1 représenté sur la figure 1 forme typiquement un point mémoire, c'est-à-dire une cellule mémoire unitaire, d'une mémoire comportant une multitude de ces dispositifs mémoires.

Comme indiqué précédemment, l'état mémoire d'un dispositif mémoire CBRAM résulte de la différence de résistivité électrique entre deux états : « ON » et « OFF ».

A l'état « OFF », les ions métalliques (ici les ions $Cu^{2+}$ pour une électrode soluble comprenant du Cu) issus de la portion de métal ionisable sont dispersés dans tout l'électrolyte solide 2. Ainsi, aucun contact électrique n'est établi entre la cathode 3 et l'anode 4, c'est-à-dire entre l'électrode supérieure et l'électrode inférieure. L'électrolyte solide comporte une zone électriquement isolante de grande résistivité entre l'anode et la cathode.

Lorsqu'un potentiel V positif est appliqué sur l'électrode soluble supérieure 4 (l'anode), une réaction d'oxydo-réduction a lieu à cette électrode, créant des ions mobiles 5. Dans le cas d'une électrode 4 de cuivre, la réaction suivante a lieu :

$$Cu \rightarrow Cu^{2+} + 2\ e^-.$$

Les ions 5 se déplacent alors dans l'électrolyte 2 sous l'effet du champ électrique appliqué aux électrodes. La vitesse de déplacement dépend de la mobilité de l'ion dans l'électrolyte en question, ce qui guide le choix du couple électrode soluble/électrolyte (exemples : $Ag/GeS$ ; $Cu/Al_2O_3$...). Les vitesses de déplacement des ions sont de l'ordre du nm/ns.

Arrivés à l'électrode inerte 3 (la cathode), les ions 5 sont réduits de par la présence d'électrons fournis par l'électrode 3, entraînant la croissance d'un filament métallique 6 selon la réaction suivante :

$$Cu^{2+} + 2\ e^- \rightarrow Cu$$

Le filament 6 croît préférentiellement dans la direction de l'électrode soluble 4.

La mémoire 1 passe alors dans l'état « ON » lorsque le filament 6 permet le contact entre les électrodes 3 et 4, rendant l'empilement conducteur. Cette phase est appelée « SET » de la mémoire.

Pour passer à l'état « OFF » (phase de « RESET » de la mémoire), une tension V négative est appliquée sur l'électrode supérieure 4, entrainant la dissolution du filament conducteur. Pour justifier cette dissolution, des mécanismes thermiques (échauffement) et d'oxydoréduction sont généralement invoqués. Plus précisément, l'étape consistant à écrire pour la première fois la mémoire 1, c'est-à-dire à former pour la première fois le filament 6 dans l'électrolyte 2 de la mémoire 1, est appelée « forming ». On entend donc par « SET » l'étape de formation du filament 6 réalisée après au moins un premier effacement de la cellule mémoire, c'est-à-dire après que le filament de la cellule mémoire a au moins été formé une première fois (étape de forming) puis dissous (étape de RESET).

Souvent, l'électrolyte 2 contient dans l'état « OFF » un filament résiduel 6 en contact avec la cathode 3. Celui-ci provient de la phase de SET précédente et n'a pas été dissous complètement lors du RESET de la mémoire. Le filament est dit résiduel lorsqu'il n'établit pas une conduction électrique suffisante entre les électrodes pour obtenir l'état « ON ».

Une voie de développement pour les mémoires CBRAM concerne la rétention de l'information, c'est-à-dire la rétention de l'état « OFF » et de l'état « ON ». On cherche à améliorer la stabilité des états isolant et conducteur, notamment pour des températures de fonctionnement élevées. Pour améliorer la rétention de l'information, des mémoires CBRAM à base d'oxyde métallique ont été proposées. De nombreuses études portent sur ces mémoires CBRAM pour améliorer leurs performances électriques. Une des difficultés des mémoires CBRAM à base d'oxyde métallique concerne en effet la difficulté de former le filament dans l'électrolyte lors de la première utilisation de la mémoire, c'est-à-dire lors de l'étape de forming. Il s'agit donc de parvenir à réduire la tension, dite « tension de forming », nécessaire à la formation du filament dans l'électrolyte lors de la première utilisation de la cellule mémoire CBRAM.

Des dispositifs de l'art antérieur sont décrits dans l'article « Superior resistive switching characteristics of Cu-Ti02 based RRAM cell », Y. Huang et al., DOI : 10.1109/INEC.2013.6466009, ainsi que dans le document US 2013/0082228 A1 intitulé « Memory device using multiple tunnel oxide layers ».

## RESUME DE L'INVENTION

L'invention vise à apporter une solution aux problèmes évoqués précédemment en proposant une cellule mémoire CBRAM à base d'oxyde métallique aux performances électriques améliorées, et en particulier avec une tension de forming réduite, en facilitant la formation du filament conducteur. Réduire la tension de forming d'une cellule mémoire CBRAM permet notamment, à tension constante, de travailler avec des temps de switch plus courts et donc d'obtenir une cellule mémoire CBRAM plus rapide. On entend par « temps de switch » de la cellule mémoire CBRAM, le temps nécessaire à la cellule mémoire CBRAM pour passer de l'état « OFF » à l'état « ON ».

Un premier aspect de l'invention concerne donc un dispositif de mémoire vive résistive comportant :

- une première électrode en matériau inerte ;
- une deuxième électrode en matériau soluble ;
- un électrolyte solide, les première et deuxième électrodes étant respectivement en contact avec l'une des faces de l'électrolyte de part et d'autre dudit électrolyte, la deuxième électrode étant apte à fournir des ions mobiles circulant dans l'électrolyte solide vers la première électrode pour former un filament conducteur entre les première et deuxième électrodes lorsqu'une tension est appliquée entre les première et deuxième électrodes ;

l'électrolyte solide comportant une région réalisée en un oxyde d'un premier métal, dit « premier oxyde métallique » et ladite région étant dopée par un deuxième métal, distinct du premier métal et apte à former un deuxième oxyde métallique, ledit deuxième métal étant choisi de sorte que le premier oxyde métallique dopé par le deuxième métal présente une énergie de bande interdite inférieure ou égale à l'énergie de bande interdite du premier oxyde métallique non dopé par le deuxième métal.

On entend par « énergie de bande interdite », ou « gap », d'un matériau, la largeur de la bande interdite dudit matériau, c'est-à-dire la différence d'énergie entre le minimum de la bande de conduction et le maximum de la bande de valence. L'invention permet avantageusement de contribuer à la création d'une pluralité de lacunes d'oxygène dans l'électrolyte, et particulièrement dans la région de l'électrolyte en premier oxyde métallique dopé par le deuxième métal.

Cette pluralité de lacunes d'oxygène permet de faciliter le déplacement des ions mobiles, et donc la formation du filament conducteur. On contribue ainsi à diminuer la tension de forming, c'est-à-dire la tension à appliquer entre l'électrode soluble et l'électrode inerte pour permettre la formation du filament conducteur lors de l'étape de forming. La quantité de lacunes d'oxygène dans ladite région en premier oxyde métallique dopé par le deuxième métal est avantageusement suffisamment importante pour réduire l'énergie de bande interdite de ladite région, et donc pour augmenter la conductivité de ladite région. Le deuxième métal est avantageusement choisi pour que l'énergie de bande interdite du premier oxyde métallique dopé par ledit deuxième métal soit inférieure ou égale à l'énergie de bande interdite du premier oxyde métallique non dopé par le deuxième métal.

Outre les caractéristiques qui viennent d'être évoquées dans le paragraphe précédent, le dispositif selon un aspect de l'invention peut présenter une ou plusieurs caractéristiques complémentaires parmi les suivantes, considérées individuellement ou selon toutes les combinaisons techniquement possibles :

- Le deuxième métal est avantageusement choisi de sorte que l'énergie de bande interdite du deuxième oxyde métallique est inférieure ou égale à l'énergie de bande interdite du premier oxyde métallique.

- Le premier oxyde métallique est avantageusement de l'oxyde de gadolinium $Gd_2O_3$ et le deuxième métal est avantageusement choisi parmi les métaux suivants :

  ∘ de l'hafnium Hf ;
  ∘ du zirconium Zr ;
  ∘ du titane Ti.

- Alternativement, l'énergie de bande interdite du deuxième oxyde métallique est supérieure à l'énergie de bande interdite du premier oxyde métallique et la concentration atomique du deuxième métal dopant au sein de la région de l'électrolyte solide est avantageusement telle que le premier oxyde métallique dopé par le deuxième métal présente une énergie de bande interdite inférieure ou égale à l'énergie de bande interdite du premier oxyde métallique non dopé par le deuxième métal.

- Le premier oxyde métallique est avantageusement de l'oxyde de gadolinium $Gd_2O_3$ et le deuxième métal est avantageusement de l'aluminium Al.

- Le premier oxyde métallique dopé par le deuxième métal présente un ratio R inférieur à 1, le ratio R s'exprimant par : R = (M1+M2)/O, avec M1 la concentration atomique de premier métal, M2 la concentration atomique de deuxième métal et O la concentration atomique de l'oxygène.
  Dans le cas où l'énergie de bande interdite du deuxième oxyde métallique est inférieure ou égale à l'énergie de bande interdite du premier oxyde métallique, le dopage est avantageusement réalisé de telle sorte que le ratio R = (M1+M2)/O du premier oxyde métallique dopé par le deuxième métal est supérieur au ratio R' = M1/O du premier oxyde métallique non dopé par le deuxième métal.
  Alternativement, dans le cas où l'énergie de bande interdite du deuxième oxyde métallique est supérieure à l'énergie de bande interdite du premier oxyde métallique, le dopage est avantageusement réalisé de telle sorte que : le ratio R = (M1+M2)/O du premier oxyde métallique dopé par le deuxième métal augmente jusqu'à ce que l'énergie de bande interdite du premier oxyde métallique dopé par le deuxième métal devienne inférieure à l'énergie de bande interdite du premier oxyde métallique non dopé par le deuxième métal.

- Alternativement, le premier oxyde métallique pourra notamment être de l'oxyde d'aluminium $Al_2O_3$, du dioxyde de zirconium $ZrO_2$, du dioxyde de titane $TiO_2$ ou de l'oxyde de tantale $Ta_2O_5$. Dans l'exemple particulier où le premier oxyde métallique est de l'oxyde d'aluminium $Al_2O_3$, le deuxième métal pourra par exemple être de l'hafnium Hf ou du titane Ti.

- Le pourcentage atomique du deuxième métal au sein de la région de l'électrolyte solide est avantageusement sensiblement compris entre 5% et 30%, et préférentiellement sensiblement compris entre 10% et 20%. La cellule mémoire présente ainsi des performances électriques améliorées. On entend par « pourcentage atomique du deuxième métal au sein de la région de l'électrolyte solide » le pourcentage atomique du deuxième métal dans le premier oxyde métallique dopé par le deuxième métal, c'est-à-dire le pourcentage d'atomes de deuxième métal par rapport à la somme des pourcentages d'atomes de premier métal, d'oxygène et de deuxième métal.

- Selon une première alternative, la région en premier oxyde métallique dopé par le deuxième métal peut être située dans une partie supérieure de l'électrolyte solide, en contact avec la deuxième électrode en matériau soluble.

- Selon une deuxième alternative, la région en premier oxyde métallique dopé par le deuxième métal peut être située dans une partie inférieure de l'électrolyte solide, en contact avec la première électrode en matériau inerte.

- Selon une troisième alternative, l'électrolyte solide comporte avantageusement :

  ◦ une première sous-couche en contact avec la première électrode en matériau inerte, et
  ◦ une deuxième sous-couche en contact avec la deuxième électrode en matériau soluble ;

  la région de l'électrolyte solide en premier oxyde métallique dopé par le deuxième métal étant une sous-couche centrale comprise entre les première et deuxième sous-couches.

- Selon une quatrième alternative, l'électrolyte solide est entièrement formé par la région en premier oxyde métallique dopé par le deuxième métal.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 illustre schématiquement le passage d'un état « OFF » à un état « ON » pour un dispositif mémoire 1 de type CBRAM.
- Les figures 2A et 2B illustrent les résultats de calculs « ab initio », réalisés pour l'exemple d'une cellule mémoire CBRAM présentant un électrolyte à base d'oxyde de gadolinium $Gd_2O_3$ et fonctionnant par transport de cuivre dans l'électrolyte pour la formation du filament conducteur.
- La figure 3 montre schématiquement la structure d'une cellule mémoire CBRAM à base d'oxyde selon un mode de réalisation de l'invention.
- La figure 4 montre schématiquement la structure d'une cellule mémoire CBRAM à base d'oxyde selon une variante du mode de réalisation de l'invention de la figure 3.
- La figure 5 montre les tensions de forming nécessaires pour obtenir un rendement de forming de 50 % pour différents types de cellules mémoires CBRAM selon l'invention, comparativement à une cellule mémoire CBRAM selon l'art antérieur.

## DESCRIPTION DETAILLEE D'AU MOINS UN MODE DE REALISATION DE L'INVENTION

Sauf précision contraire, un même élément apparaissant sur des figures différentes présente une référence unique.

Dans la présente description, on entend par « cellule mémoire CBRAM à base d'oxyde » une cellule mémoire CBRAM comportant un électrolyte réalisé à base d'un oxyde métallique. Une des difficultés des mémoires CBRAM à base d'oxyde concerne la formation du filament dans l'électrolyte. En effet, les oxydes métalliques étant des matériaux denses, il est difficile d'introduire des atomes constitutifs du filament dans un électrolyte à base d'oxyde métallique.

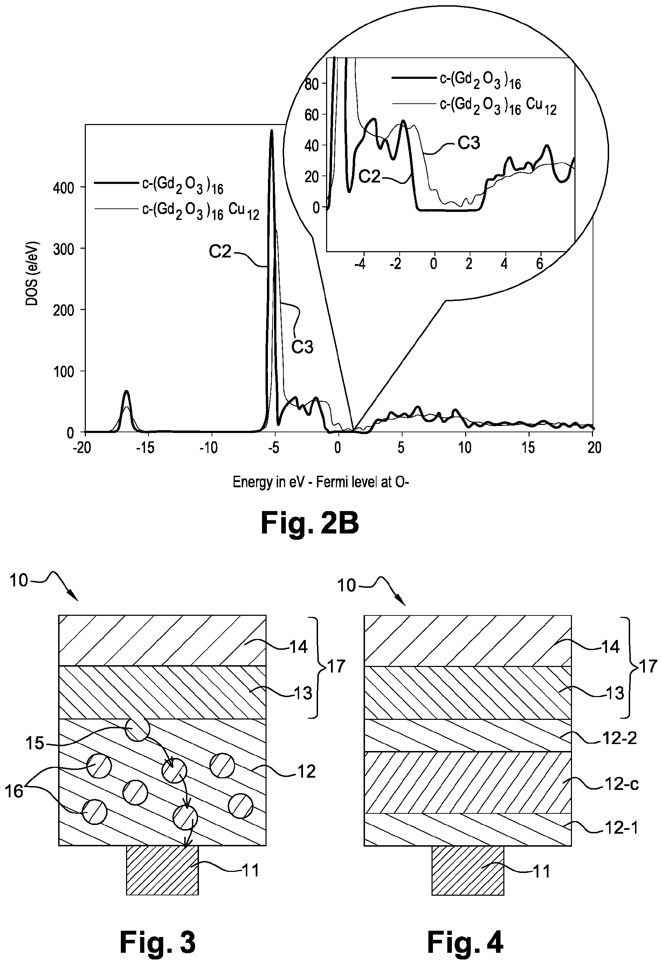

Les figures 2A et 2B illustrent les résultats de calculs « ab initio », réalisés pour l'exemple d'une cellule mémoire CBRAM présentant un électrolyte à base d'oxyde de gadolinium $Gd_2O_3$ et fonctionnant par transport de cuivre dans l'électrolyte pour la formation du filament conducteur.

La figure 2A montre ainsi une première courbe C1 de l'évolution de l'énergie de formation, mesurée en eV, du filament conducteur en fonction du nombre d'atomes de cuivre présents dans l'électrolyte.

La première courbe C1 indique une augmentation continue de l'énergie de formationen fonction du nombre d'atomes de cuivre dans l'électrolyte.

La figure 2B montre quant à elle :

- une deuxième courbe C2 de l'évolution de la densité d'états en fonction de l'énergie dans l'électrolyte lorsqu'aucun atome de cuivre n'est introduit dans l'électrolyte ;
- une troisième courbe C3 de l'évolution de la densité d'états en fonction de l'énergie dans l'électrolyte lorsque des atomes de cuivre sont introduits dans l'électrolyte.

La densité d'états est mesurée en nombre d'états électroniques par eV. L'énergie est mesurée en eV. On représente plus exactement, en abscisse de la figure 2B, l'énergie moins l'énergie de Fermi, mesurée en eV. Le niveau de Fermi se trouve ainsi à l'abscisse nulle. La deuxième courbe C2 montre que, lorsqu'aucun atome de cuivre n'est inclus dans l'électrolyte, le niveau de Fermi se trouve dans la bande interdite, ou « gap », du matériau de l'électrolyte, qui ne comporte aucun état électronique : l'électrolyte est isolant. La troisième courbe C3 montre que, lorsque des atomes de cuivre sont inclus dans l'électrolyte, des états électroniques apparaissent dans ce qui était précédemment la bande interdite du matériau de l'électrolyte. Cela traduit le fait que l'électrolyte devient conducteur, c'est-à-dire que le filament se forme.

Le tableau ci-dessous regroupe des résultats de simulations « ab initio » réalisées pour de l'oxyde de gadolinium $Gd_2O_3$ cubique. L'énergie nécessaire pour insérer un atome de cuivre dans l'électrolyte, ou enthalpie de formation $\Delta H_f$, est calculée selon la formule :

$$\Delta H_f = U(Gd_2O_3{:}Cu^{+q}) - U(Gd_2O_3) + U\left(O_{(g)}\right) - U\left(Cu_{(s)}\right) + q \times \mu_e$$

$U(espèce)$ désigne l'énergie interne d'une espèce ; $\mu_e$ désigne le potentiel chimique d'un électron et q désigne la charge d'un électron.

| | Enthalpie de formation $\Delta H_f$ (eV) | Stress (GPa) |
|---|---|---|
| Atome de Cu interstitiel | 3,77 | 1,23 |
| Atome de Cu substitué à un atome d'O | 8,84 | -1,41 |
| Atome de Cu substitué à un atome de Gd | 10,50 | -1,40 |
| Atome de Cu interstitiel et lacune d'un atome d'O | 8,84 | -1,41 |
| Lacune d'un atome d'O | 7,41 | 0,15 |
| Atome de Cu interstitiel dans une lacune d'un atome d'O initialement présente | 1,43 | 1,38 |
| Atome d'O interstitiel | 1,10 | $-10^{-3}$ |

Ces simulations montrent que l'insertion d'un atome de cuivre en interstitiel dans de l'oxyde de gadolinium $Gd_2O_3$ est une configuration plus favorable, c'est-à-dire nécessitant moins d'énergie et ayant une enthalpie de formation $\Delta H_f$ plus faible, que la substitution d'un atome d'oxygène ou de gadolinium par un atome de cuivre. L'enthalpie de formation pour l'insertion d'un atome de cuivre en interstitiel vaut en effet 3,77 eV, tandis que l'enthalpie de formation pour la substitution d'un atome de cuivre à un atome de gadolinium (respectivement, à un atome d'oxygène) vaut 10,50 eV (respectivement, 8,84 eV).

Lorsque des lacunes d'oxygène sont présentes dans le $Gd_2O_3$, le coût énergétique pour introduire du cuivre dans le $Gd_2O_3$ est réduit de 3,77 eV à 1,43 eV. Ces calculs ab initio permettent donc de conclure que la présence de lacunes d'oxygène favorise l'introduction de cuivre dans l'oxyde de gadolinium, donc la formation du filament au sein de l'électrolyte.

La figure 3 montre schématiquement la structure d'une cellule mémoire CBRAM 10 à base d'oxyde selon un premier mode de réalisation de l'invention. La cellule mémoire 10 comporte :

- une première électrode 11, également appelée cathode ou électrode inerte par la suite ;
- un électrolyte solide 12. L'électrolyte solide 12 comporte une région en oxyde d'un premier métal, dit « premier oxyde métallique », ladite région étant dopée par un deuxième métal, distinct du premier métal et apte à former un deuxième oxyde métallique. Le premier oxyde métallique dopé par le deuxième métal présente une énergie de bande interdite inférieure ou égale à l'énergie de bande interdite du premier oxyde métallique non dopé par le deuxième métal. La diminution de l'énergie de bande interdite du premier oxyde métallique dopé par rapport au premier oxyde métallique non dopé traduit l'augmentation de la quantité de lacunes d'oxygène 16 dans ledit premier oxyde métallique dopé de l'électrolyte solide 12 ;
- une deuxième électrode 17, également appelée anode ou électrode soluble par la suite, et comportant une couche de source d'ions 13 et une ligne métallique 14 ;

Lorsqu'une tension est appliquée entre l'électrode inerte 11 et la ligne métallique 14 de l'électrode soluble 17, la couche de source d'ions 13 fournit des ions mobiles 15 qui circulent dans l'électrolyte solide 12 vers l'électrode inerte 11 pour former un filament conducteur entre l'électrode inerte 11 et l'électrode soluble 17. Les lacunes d'oxygène 16 facilitent l'inclusion interstitielle des ions mobiles 15 dans l'électrolyte solide 12.

Selon le premier mode de réalisation illustré à la figure 3, l'électrode inerte 11 est un plot, par exemple réalisé à partir d'un métal inerte d'interconnexion, tel que du tungstène W, du nitrure de titane TiN ou du nitrure de tantale TaN.

Selon le premier mode de réalisation illustré à la figure 3, l'électrolyte solide 12 est réalisé en oxyde de gadolinium $Gd_2O_3$ et le deuxième métal dopant est de l'hafnium Hf. Alternativement, le deuxième métal dopant pourra notamment être du zirconium Zr, de l'aluminium Al ou du titane Ti.

Selon le premier mode de réalisation illustré à la figure 3, la couche de source d'ions 13 de l'électrode soluble 17 est réalisée à partir d'un alliage de cuivre Cu et d'un élément de la famille des chalcogènes tel que du Te. La couche de source d'ions 13 de l'électrode soluble 17 peut donc être réalisée à partir de CuTe. Plus généralement, la couche de source d'ions 13 peut être réalisée à partir de cuivre Cu et de ses alliages, d'argent Ag et de ses alliages, de zinc Zn et de ses alliages, d'un alliage de cuivre et/ou de zinc et/ou d'argent, tel que : AgCu, AgZn, CuZn, AgCuZn, et de ses alliages.

Plusieurs variantes sont possibles pour le premier mode de réalisation selon lequel la région de l'électrolyte solide 12 est dopée avec de l'hafnium Hf, parmi lesquelles :

- une première variante selon laquelle l'ensemble de l'électrolyte solide 12 est dopé, le pourcentage atomique de l'hafnium Hf dans l'électrolyte solide 12 étant sensiblement égal à 15% ;
- une deuxième variante, plus particulièrement illustrée à la figure 4, selon laquelle la région dopée de l'électrolyte solide 12 est une sous-couche centrale 12-c dudit électrolyte solide 12, le pourcentage atomique de l'hafnium Hf dans la sous-couche centrale 12-c étant sensiblement égal à 20%. La sous-couche centrale 12-c de l'électrolyte solide 12 est comprise entre des première et deuxième sous-couches 12-1 et 12-2 de l'électrolyte solide 12, la première sous-couche 12-1 étant en contact avec l'électrode inerte 11, et la deuxième sous-couche 12-2 étant en contact avec la couche de source d'ions 13.

Selon un deuxième mode de réalisation de l'invention, l'électrolyte solide 12 est réalisé en oxyde de gadolinium $Gd_2O_3$ et le deuxième métal dopant est du titane Ti, le pourcentage atomique de titane Ti dans l'électrolyte solide 12 étant sensiblement égal à 18%.

Selon le premier mode de réalisation, l'énergie de bande interdite de l'électrolyte solide en $Gd_2O_3$ dopé à l'hafnium est typiquement de l'ordre de 4,4 eV +/- 1 eV, en fonction notamment du mode de dépôt, de la qualité du matériau, etc.

Selon le deuxième mode de réalisation, l'énergie de bande interdite de l'électrolyte solide en $Gd_2O_3$ dopé au titane est typiquement de l'ordre de 4,1 eV +/- 1 eV, en fonction notamment du mode de dépôt, de la qualité du matériau, etc.

En comparaison, une énergie de bande interdite de l'ordre de 6 eV a été mesurée pour un électrolyte solide en oxyde de gadolinium $Gd_2O_3$ non dopé.

Plus généralement, que la région en premier oxyde métallique dopé par le deuxième métal forme l'ensemble de l'électrolyte solide 12 ou uniquement une partie de l'électrolyte solide 12, ladite région en premier oxyde métallique dopé par le deuxième métal présente un pourcentage atomique de deuxième métal compris entre 5% et 30%, et préférentiellement compris entre 10% et 20%.

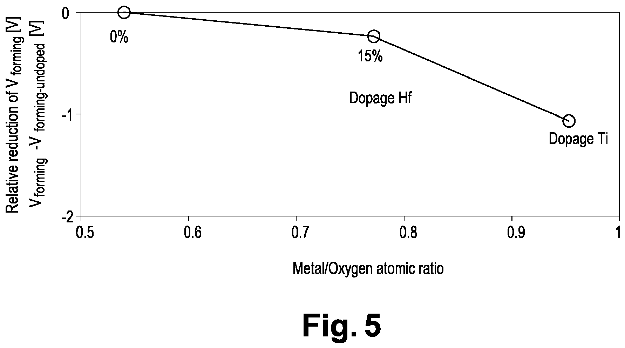

La figure 5 décrite ci-après réunit plusieurs résultats expérimentaux permettant de montrer quantitativement l'amélioration des performances électriques de cellules mémoires CBRAM selon l'invention, par rapport à une cellule mémoire CBRAM classique selon l'état de la technique.

La figure 5 montre ainsi les tensions de forming nécessaires pour obtenir un rendement de forming correspondant à la valeur médiane de la tension de formation du filament, pour une expérience portant sur une centaine de cellules mémoires CBRAM. Pour rappel, on entend par « forming » d'une cellule mémoire CBRAM l'étape consistant à écrire pour la première fois ladite cellule mémoire CBRAM, c'est-à-dire à former pour la première fois le filament dans l'électrolyte de ladite cellule mémoire CBRAM. Un rendement de forming de 50% signifie donc que les filaments de 50% des cellules mémoires testées ont effectivement été formés pour la première fois. Les expériences dont les résultats sont rassemblés en figure 5 ont été effectuées sur des échantillons dont la taille est de l'ordre de cent cellules mémoires CBRAM.

- La tension de forming pour une cellule mémoire CBRAM selon la première variante du premier mode de réalisation, présentant un électrolyte solide en $Gd_2O_3$ dopé avec un pourcentage atomique d'hafnium Hf de l'ordre de 15%, est réduite de l'ordre de 350 mV par rapport au cas de référence.
- La tension de forming pour une cellule mémoire CBRAM selon le deuxième mode de réalisation de l'invention, c'est-à-dire qui présente un électrolyte solide en $Gd_2O_3$ dopé avec un pourcentage atomique de titane Ti de l'ordre de 18%, est réduite de l'ordre de 1,1 V par rapport au cas de référence.

Plusieurs variantes de réalisation d'une cellule mémoire CBRAM selon l'invention ont été décrites jusqu'à présent. On donne ainsi plusieurs exemples de dopants possibles et plusieurs exemples de pourcentages atomiques possibles desdits dopants au sein de la région dopée de l'électrolyte solide 12. Ladite région dopée de l'électrolyte solide 12 peut en outre être une partie, ou l'ensemble de l'électrolyte solide 12.

Nous décrivons à présent un exemple de règle expérimentale permettant de contribuer à déterminer des variantes supplémentaires de cellules mémoires CBRAM conformes à l'invention. On rappelle ici que la région dopée de l'électrolyte solide 12 est réalisée en premier oxyde métallique dopé par le deuxième métal. Le premier oxyde métallique présente un premier ratio métal/oxyde R1, qui s'exprime ainsi: $R1 = M1/O$, avec M1 la concentration atomique du premier métal et O la concentration atomique de l'oxygène. Le premier oxyde métallique dopé par le deuxième métal présente quant à lui un deuxième ratio métal/oxyde R2, qui s'exprime ainsi : $R2 = (M1 + M2)/O$, avec M1 la concentration atomique de premier métal, M2 la concentration atomique de deuxième métal et O la concentration atomique de l'oxygène.

Afin d'obtenir une cellule mémoire CBRAM conforme à l'invention, il s'agit que le deuxième ratio métal/oxyde R2 respecte la première condition suivante : R2 > R1. Avantageusement, le deuxième ratio métal/oxyde R2 respecte également la deuxième condition suivante : R2 < 1.

La première condition permet, en s'éloignant du premier ratio métal/oxyde R1 correspondant au premier oxyde métallique stoechiométrique, de faciliter l'inclusion d'ions mobiles dans la région dopée de l'électrolyte solide oxyde 12. La deuxième condition permet avantageusement de contribuer à ce que le premier oxyde métallique dopé par le deuxième métal continue de présenter une isolation électrique suffisante, c'est-à-dire typiquement une résistance supérieure à 10 kΩ.

La région dopée de l'électrolyte solide 12 peut par exemple être réalisée en effectuant une copulvérisation d'une cible de premier oxyde métallique et d'une cible de deuxième métal. Il est notamment possible de mesurer le pourcentage atomique du deuxième métal dopant au sein de la région dopée de l'électrolyte solide 12 par une technique de spectroscopie de rétrodiffusion de Rutherford RBS (de l'anglais « Rutherford Backscattering Spectroscopy »).

Le dispositif selon l'invention n'est naturellement pas limité aux variantes de réalisation qui viennent d'être décrites à titre indicatif et nullement limitatif en référence aux figures 2A à 5. Ainsi, même si l'invention a été décrite de manière illustrative pour un électrolyte solide oxyde réalisé à base de $Gd_2O_3$, plusieurs autres cas sont envisageables. On cite à titre d'exemple les configurations suivantes, considérées individuellement ou selon toutes les combinaisons techniquement possibles :

- l'électrolyte solide oxyde comporte au moins une bicouche de type $Gd_2O_3/Al_2O_3$, $Gd_2O_3/GeO$, $Gd_2O_3/La_2O_3$, $Gd_2O_3/Li_2O$, $Gd_2O_3/B_2O_3$, $Gd_2O_3/WO_2$, $Gd_2O_3/VO_2$, $Gd_2O_3/V_2O_5$, $Gd_2O_3/MgO$ ou $Gd_2O_3/MgAl_2O_4$ ;
- l'électrolyte solide oxyde comporte au moins une tricouche de type $Gd_2O_3/Al_2O_3/Gd_2O_3$, $Gd_2O_3/GeO/Gd_2O_3$, $Gd_2O_3/La_2O_3/Gd_2O_3$, $Gd_2O_3/Li_2O/Gd_2O_3$, $Gd_2O_3/B_2O_3/Gd_2O_3$, $Gd_2O_3/WO_2/Gd_2O_3$, $Gd_2O_3/VO_2/Gd_2O_3$, $Gd_2O_3/V_2O_5/Gd_2O_3$, $Gd_2O_3/MgO/Gd_2O_3$, $Gd_2O_3/MgAl_2O_4/Gd_2O_3$ ;
- le premier oxyde métallique est de l'oxyde d'aluminium $Al_2O_3$, du dioxyde de zirconium $ZrO_2$, du dioxyde de titane $TiO_2$ ou de l'oxyde de tantale $Ta_2O_5$.

## Revendications

1. Dispositif (10) de mémoire vive résistive comportant :

   - une première électrode (11) en matériau inerte ;
   - une deuxième électrode (17) en matériau soluble ;
   - un électrolyte solide (12), les première et deuxième électrodes (11, 17) étant respectivement en contact avec l'une des faces de l'électrolyte (12) de part et d'autre dudit électrolyte, la deuxième électrode (17) étant apte à fournir des ions mobiles (15) circulant dans l'électrolyte solide (12) vers la première électrode (11) pour former un filament conducteur entre les première et deuxième électrodes lorsqu'une tension est appliquée entre les première et deuxième électrodes ;

   ledit dispositif (10) étant **caractérisé en ce que** l'électrolyte solide (12) comporte une région réalisée en un oxyde d'un premier métal, dit « premier oxyde métallique » et **en ce que** ladite région est dopée par un deuxième métal, distinct du premier métal et apte à former un deuxième oxyde métallique, ledit deuxième métal étant choisi de sorte que le premier oxyde métallique dopé par le deuxième métal présente une énergie de bande interdite inférieure ou égale à l'énergie de bande interdite du premier oxyde métallique non dopé par le deuxième métal.

2. Dispositif (10) selon la revendication 1 **caractérisé en ce que** ledit deuxième métal est choisi de sorte que l'énergie de bande interdite du deuxième oxyde métallique est inférieure ou égale à l'énergie de bande interdite du premier oxyde métallique.

3. Dispositif (10) selon la revendication 1 **caractérisé en ce que** l'énergie de bande interdite du deuxième oxyde métallique est supérieure à l'énergie de bande interdite du premier oxyde métallique et **en ce que** la concentration atomique du deuxième métal dopant au sein de la région de l'électrolyte solide (12) est telle que le premier oxyde métallique dopé par le deuxième métal présente une énergie de bande interdite inférieure ou égale à l'énergie de bande interdite du premier oxyde métallique non dopé par le deuxième métal.

4. Dispositif (10) selon la revendication 2 **caractérisé en ce que** le premier oxyde métallique est de l'oxyde de gadolinium $Gd_2O_3$ et **en ce que** le deuxième métal est choisi parmi les métaux suivants :

   - de l'hafnium Hf ;
   - du zirconium Zr ;
   - du titane Ti.

5. Dispositif (10) selon la revendication 3 **caractérisé en ce que** le premier oxyde métallique est de l'oxyde de gadolinium $Gd_2O_3$ et **en ce que** le deuxième métal est de l'aluminium Al.

6. Dispositif (10) selon l'une quelconque des revendications 1 à 3 **caractérisé en ce que** le premier oxyde métallique est de l'oxyde d'aluminium $Al_2O_3$, du dioxyde de zirconium $ZrO_2$, du dioxyde de titane $TiO_2$ ou de l'oxyde de tantale $Ta_2O_5$.

7. Dispositif (10) selon l'une quelconque des revendications précédentes **caractérisé en ce que** le premier oxyde métallique dopé par le deuxième métal présente un ratio R inférieur à 1, le ratio R s'exprimant par : R = (M1+M2)/O, avec M1 la concentration atomique de premier métal, M2 la concentration atomique de deuxième métal et O la concentration atomique de l'oxygène.

8. Dispositif (10) selon l'une quelconque des revendications précédentes **caractérisé en ce que** le pourcentage atomique du deuxième métal au sein de la région de l'électrolyte solide (12) est sensiblement compris entre 5% et 30% et préférentiellement entre 10% et 20%.

9. Dispositif (10) selon l'une quelconque des revendications précédentes **caractérisé en ce que** l'électrolyte solide (12) comporte :

   - une première sous-couche (12-1) en contact avec la première électrode (11) en matériau inerte, et
   - une deuxième sous-couche (12-2) en contact avec la deuxième électrode (17) en matériau soluble ;

la région de l'électrolyte solide (12) en premier oxyde métallique dopé par le deuxième métal étant une sous-couche centrale (12-c) comprise entre les première et deuxième sous-couches (12-1, 12-2).

10. Dispositif (10) selon l'une quelconque des revendications 1 à 9 **caractérisé en ce que** l'électrolyte solide (12) est entièrement formé par la région en premier oxyde métallique dopé par le deuxième métal.

**Patentansprüche**

1. Ohmsche Arbeitsspeichervorrichtung (10), umfassend:

   - eine erste Elektrode (11) aus inertem Material;
   - eine zweite Elektrode (17) aus löslichem Material;
   - ein fester Elektrolyt (12), wobei die erste und zweite Elektrode (11, 17) jeweils in Kontakt mit einer der Seiten der Elektrode (12) auf jeder Seite des genannten Elektrolyts sind, wobei die zweite Elektrode (17) geeignet ist, mobile Ionen (15) zu liefern, die in dem festen Elektrolyt (12) zur ersten Elektrode (11) zirkulieren, um einen leitenden Draht zwischen der ersten und zweiten Elektrode zu bilden, wenn eine Spannung zwischen der ersten und zweiten Elektrode angewendet ist;

wobei die genannte Vorrichtung (10) **dadurch gekennzeichnet ist, dass** der feste Elektrolyt (12) einen Bereich umfasst, der aus einem Oxid eines ersten Metalls, bezeichnet als "erstes Metalloxid" realisiert ist und dass der genannte Bereich durch ein zweites Metall gedopt ist, das von dem ersten Metall unterschiedlich ist und geeignet ist, ein zweites Metalloxid zu formen, wobei das genannte zweite Metall derart ausgewählt ist, dass das erste, mit dem zweiten Metall gedopte Metalloxid eine verbotene Bandenergie aufweist, die geringer als oder gleich wie die verbotene Bandenergie des ersten, nicht durch das zweite Metall gedopten Metalloxids ist.

**2.** Vorrichtung (10) gemäß Anspruch 1, **dadurch gekennzeichnet, dass** das genannte zweite Metall derart ausgewählt ist, dass die verbotene Bandenergie des zweiten Metalloxids geringer als oder gleich wie die verbotene Bandenergie des ersten Metalloxids ist.

**3.** Vorrichtung (10) gemäß Anspruch 1, **dadurch gekennzeichnet, dass** die verbotene Bandenergie des zweiten Metalloxids stärker ist als die verbotene Bandenergie des ersten Metalloxids und dass die Atomkonzentration des zweiten dopenden Metalls in dem Bereich des festen Elektrolyts (12) derart ist, dass das erste, durch das zweite Metall gedopte Metalloxid eine verbotene Bandenergie aufweist, die geringer als oder gleich wie die verbotene Bandenergie des ersten, nicht mit dem zweiten Metall gedopten Metalloxid ist.

**4.** Vorrichtung (10) gemäß Anspruch 2, **dadurch gekennzeichnet, dass** das erste Metalloxid Gadoliniumoxid $Gd_2O_3$ ist und dass das zweite Metall ausgewählt ist aus den folgenden Metallen:

- Hafnium Hf;
- Zirkonium Zr;
- Titan Ti.

**5.** Vorrichtung (10) gemäß Anspruch 3, **dadurch gekennzeichnet, dass** das erste Metalloxid Gadoliniumoxid $Gd_2O_3$ ist und dass das zweite Metall Al ist.

**6.** Vorrichtung (10) gemäß irgendeinem der Ansprüche 1 bis 3, **dadurch gekennzeichnet, dass** das erste Metalloxid Aluminiumoxid $Al_2O_3$, Zirkoniumdioxid $ZrO_2$, Titandioxid $TiO_2$ oder Tantaloxid $Ta_2O5$ ist.

**7.** Vorrichtung (10) gemäß einem der voranstehenden Ansprüche, **dadurch gekennzeichnet, dass** das erste, mit dem zweiten Metall gedopte Metalloxid ein Verhältnis R kleiner als 1 aufweist, wobei das Verhältnis R ausgedrückt ist durch: R = (M1+M2)/O, wobei M1 die Atomkonzentration des ersten Metalls, M2 die Atomkonzentration des zweiten Metall und O die Atomkonzentration des Sauerstoffs ist.

**8.** Vorrichtung (10) gemäß irgendeinem der voranstehenden Ansprüche, **dadurch gekennzeichnet, dass** der Atomprozentsatz des zweiten Metalls innerhalb des Bereichs des festen Elektrolyts (12) deutlich zwischen 5 % und 30 % und bevorzugt zwischen 10 % und 20 % inbegriffen ist.

**9.** Vorrichtung (10) gemäß irgendeinem der voranstehenden Ansprüche, **dadurch gekennzeichnet, dass** das feste Elektrolyt (12) umfasst:

- eine erste Unterschicht (12-1), die mit der ersten Elektrode (11) aus inertem Material in Kontakt ist; und
- eine zweite Unterschicht (12-2), die mit der zweiten Elektrode (17) aus löslichem Material in Kontakt ist;

wobei der Bereich des festen Elektrolyts (12) aus dem ersten, mit dem zweiten Metall gedoptem Metalloxid eine zentrale Unterschicht (12-c) ist, die zwischen der ersten und der zweiten Schicht (12-1, 12-2) inbegriffen ist.

**10.** Vorrichtung (10) gemäß irgendeinem der Ansprüche 1 bis 9, **dadurch gekennzeichnet, dass** das feste Elektrolyt (12) komplett durch den Bereich aus dem ersten, mit dem zweiten Metall gedoptem Metalloxid geformt ist.

**Claims**

**1.** Resistive random access memory device (10) comprising:

- a first electrode (11) made of inert material;
- a second electrode (17) made of soluble material;
- a solid electrolyte (12), the first and second electrodes (11, 17) being respectively in contact with one of the faces of the electrolyte (12) on either side of said electrolyte, the second electrode (17) being capable of providing mobile ions (15) flowing in the solid electrolyte (12) to the first electrode (11) to form a conductive filament between the first and second electrodes when a voltage is applied between the first and second electrodes;

said device (10) being **characterised in that** the solid electrolyte (12) comprises a region made of an oxide of a first metal, called "first metal oxide", and **in that** said region is doped with a second metal, different from the first metal and capable of forming a second metal oxide, said second metal being selected so that the first metal oxide doped with the second metal has a bandgap energy less than or equal to the bandgap energy of the first metal oxide not doped with the second metal.

2. Device (10) according to claim 1 **characterised in that** said second metal is selected so that the bandgap energy of the second metal oxide is less than or equal to the bandgap energy of the first metal oxide.

3. Device (10) according to claim 1 **characterised in that** the bandgap energy of the second metal oxide is greater than the bandgap energy of the first metal oxide and **in that** the atomic concentration of the second doping metal within the region of the solid electrolyte (12) is such that the first metal oxide doped with the second metal has a bandgap energy less than or equal to the bandgap energy of the first metal oxide not doped with the second metal.

4. Device (10) according to claim 2 **characterised in that** the first metal oxide is gadolinium oxide $Gd_2O_3$ and **in that** the second metal is selected from among the following metals:

   - hafnium Hf;
   - zirconium Zr;
   - titanium Ti.

5. Device (10) according to claim 3 **characterised in that** the first metal oxide is gadolinium oxide $Gd_2O_3$ and **in that** the second metal is aluminium Al.

6. Device (10) according to any of claims 1 to 3 **characterised in that** the first metal oxide is aluminium oxide $Al_2O_3$, zirconium oxide $ZrO_2$, titanium dioxide $TiO_2$ or tantalum oxide $Ta_2O_5$.

7. Device (10) according to any of the preceding claims **characterised in that** the first metal oxide doped with the second metal has a ratio R less than 1, the ratio R being expressed by: R = (M1 + M2)/O, with M1 the atomic concentration of the first metal, M2 the atomic concentration of the second metal and O the atomic concentration of oxygen.

8. Device (10) according to any of the preceding claims **characterised in that** the atomic percentage of the second metal within the region of the solid electrolyte (12) is substantially comprised between 5% and 30% and preferentially between 10% and 20%.

9. Device (10) according to any of the preceding claims **characterised in that** the solid electrolyte (12) comprises:

   - a first sub-layer (12-1) in contact with the first electrode (11) made of inert material, and
   - a second sub-layer (12-2) in contact with the second electrode (17) made of soluble material;

   the region of the solid electrolyte (12) made of the first metal oxide doped with the second metal being a central sub-layer (12-c) comprised between the first and second sub-layers (12-1, 12-2).

10. Device (10) according to any of claims 1 to 9 **characterised in that** the solid electrolyte (12) is entirely formed by the region made of the first metal oxide doped with the second metal.

**Fig. 1**

**Fig. 2A**

**Fig. 2B**

**Fig. 3**

**Fig. 4**

**Fig. 5**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20130082228 A1

**Littérature non-brevet citée dans la description**

- **Y. HUANG et al.** *Superior resistive switching characteristics of Cu-Ti02 based RRAM cell*